# EUROPEAN PATENT SPECIFICATION

(11) **EP 1 048 758 B1**
(45) Date of publication and mention of the grant of the patent: **27.10.2004**
(21) Application number: 00106163.9
(22) Date of filing: 21.03.2000
(51) Int. Cl.: C30B 11/00, C30B 29/06

(54) **Method for producing crystalline silicon**
Verfahren zur Herstellung von kristallinem Silizium
Procédé pour la production de silicium cristallin

(30) Priority: 30.04.1999 JP 12533999; 29.02.2000 JP 2000054820
(43) Date of publication of application: 02.11.2000
(73) Proprietor: MITSUBISHI MATERIALS CORPORATION, Chiyoda-ku, Tokyo (JP)
(72) Inventor: Wakita, Saburo, Mitsubishi Materials Corporation, 1-297 Kitabukuro-cho, Omiya (JP); Nakada, Yoshinobu, Mitsubishi Materials Corp., 1-297 Kitabukuro-cho, Omiya (JP); Sasaki, Junichi, Mitsubishi Materials Corporation, 1-297 Kitabukuro-cho, Omiya (JP); Ishiwari, Yuji, Mitsubishi Materials Corporation, 1-297 Kitabukuro-cho, Omiya (JP)
(74) Representative: Gille Hrabal Struck Neidlein Prop Roos

(56) References cited:
- EP-A- 0 867 405
- EP-A- 0 887 442
- WO-A-98/16466
- PATENT ABSTRACTS OF JAPAN vol. 1998, no. 12, 31 October 1998 (1998-10-31) & JP 10 182135 A (KAWASAKI STEEL CORP), 7 July 1998 (1998-07-07)

## Description

The present invention relates to a method for producing crystalline silicon which is obtained by gradual solidification in a unidirectional way with cooling a molten silicon.

Polycrystalline silicon solar cells are solar cells which are nowadays produced in the largest quantity.

The performance of a solar cell element of polycrystalline silicon solar cell greatly depends on the quality of a polycrystalline silicon. For this reason, various improvements have been made on producing the polycrystalline silicon, and the most important subjects in the production thereof are to decrease impurities in crystal and to improve crystallinity.

The production process of polycrystalline silicon is roughly divided into two steps which comprise one process for producing a high-purity silicon from a metallic silicon and the other process for solidifying a molten silicon of the high-purity silicon by a unidirectional solidification method. Conventionally, in order to decrease impurity elements, in the former method, the metallic silicon is reacted with hydrochloric acid to obtain gasfied trichlorosilane, followed by rectifying the gasfied trichlorosilane and then precipitating a high-purity silicone from the gas while reacting the rectified gas with a hydrogen gas, thereby to produce the high-purity silicone.

It is also effective that silicon is unidirectionally solidified while stirring the molten silicone such that impurity elements can be decreased.

The following methods, for examples, are disclosed for stirring. JP-A 61-141612 discloses a method of turning a mold, JP-A 5-254817 discloses a method of generating a stirring power in a molten silicon owing to a magnetic field action, and JP-A 10-182135 discloses a method which comprises inserting a lance into a position above the solid-liquid phase boundary of a molten silicon and blowing an inert gas.

However, the above-mentioned first method has problems in equipment costs, maintenance method and high production costs. The second method also has a problem in high equipment costs. The third method has a problem in that the lance melts to become impurities in the molten silicon with the result of decreasing the purity of silicon.

In case of having a high oxygen content, the cell properties of a solar cell lowers. As a quantity of oxygen dissolves and is contained in a lump remelt which is a scrap of single crystal silicon used as main raw material, it is necessary to decrease the oxygen in the process of melting and unidirectional solidification. Further, when the surface of molten silicon is not covered by an inert gas, CO gas, SiO gas and the like will enter into the molten silicon, thereby increasing the impurity content of the molten silicon and lowering the above-mentioned cell properties.

In a further known method for producing silicon for use in solar cells (EP 0 867 405 A1) molten silicon is poured into a deep mold for solidifying upward while providing to the suface of the molten silicone in the mold heat by means of burners arranged above the molten silicon in the mold. No means are provided to inhibit impurities as CO gas or SiO gas to enter into the molten silicon from the surrounding atmosphere.

The present invention has been carried out, considering the above-mentioned situation.

The object of the present invention is to provide a method for producing a crystalline silicon which enables to produce at low cost and easily polycrystalline silicon having a high quality with a low impurity content and a high crystallinity.

This above-mentioned object is attained in accordance with the present invention by a method as claimed in independent claim 1.

Improved embodiments and further advantages of the invention are subject matter of the subclaims dependent from claim 1.

In accordance with the present invention a crystalline silicon is produced which crystallizes molten silicon from the inner bottom of a mold upward while providing to the molten silicone in the mold a temperature having a positive gradient from the inner bottom of the mold upward, wherein an inert gas is blown to the surface of the molten silicon from the upper position above the surface thereof to vibrate the surface of the molten silicon in such a manner that cavities are formed in the surface thereof.

In this method for producing a crystalline silicon, an inert gas such as Ar gas is blown to the surface of the molten silicon and the surface of the molten silicon is vibrated in such a degree that cavities are formed in the surface thereof with the result that fresh surfaces are continuously formed in the surface, thereby to promote to discharge a SiO gas generating in the interior of the molten silicon to the surrounding atmosphere and to enable to effectively remove O which is an impurity in the molten silicon.

In addition, as a gas-supplying lance is not put into the molten silicon, impurities cannot enter into the molten silicon from the lance and contaminate the molten silicon.

In accordance with the present invention a susceptor is disposed above the surface of the molten silicon and the inert gas is introduced into a space between the susceptor and molten silicon through a part of the susceptor.

In this method for producing a crystalline silicon, the inert gas existing near the surface of the molten silicon is restrained from diffusing in the surrounding by the susceptor and the inert gas can cover the surface of the molten silicon for a long time. Therefore, CO gas and SiO gas in the surrounding atmosphere are effectively prevented from entering Into the molten silicon by a small flow rate of the inert gas.

In an improved embodiment of the present invention, the entire surface of the molten silicon is covered with inert gas. As the surface of the molten silicon is covered with the inert gas such as Ar gas, impurity gases such as CO gas and SiO gas in the surrounding atmosphere are prevented from entering into the molten silicon.

In accordance with a further aspect of the present invention the flow rate of the blown inert gas is decreased according to moving of the solid-liquid phase boundary of silicon in the mold upward. In this embodiment of the present invention the solid-liquid phase boundary of the molten silicon is restrained from being disturbed by the blown inert gas.

In a preferred embodiment of the invention the flow rate of the blown gas, an inside radius of the gas-supplying lance which introduces the inert gas into the surface of the molten silicon and the distance from a port of the lance to the surface of the molten silicon satisfy the following formula;$\text{3 ≤ f/(rH) ≤ 60}$ wherein
f [ l/min ] is the flow rate of blown inert gas;
r [ cm ] is an inside radius of the lance; and
H [ cm ] is the distance from a port of the lance to the surface of the molten silicon

In the above-mentioned method for producing a crystalline silicon, the surface of the molten silicon is vibrated under conditions selected such that the flow rate of the blown gas, the inside radius of the gas-supplying lance and the distance from the port of the lance to the surface of the molten silicon are effective and proper for promoting to discharge to the surrounding atmosphere SiO gas which generates in the interior of the molten silicon. Therefore, O can be decreased which is an impurity in the molten silicon.

In a further aspect of the present invention the number of lance nozzles is single or plural according to the surface area of the molten silicon.

In this method for producing a crystalline silicon the surface of the molten silicon is vibrated by the selected number of lance(s) according to the surface area of the molten silicon so as to be effective and proper for promoting to discharge to the surrounding atmosphere SiO gas which generates in the interior of the molten silicon. Therefore, O can be decreased which is an impurity in the molten silicon.

Preferable embodiments of the method for producing a crystalline silicon in the present invention are described hereinafter with reference to drawings, wherein
- Fig. 1: is a schematic sectional view showing the front of the mold periphery of an equipment for producing crystalline silicone which is used in an embodiment of the method for producing crystal silicon according to the present invention,
- Fig. 2: is a plan of Fig. 1 viewed from a gas-supplying lance for illustrating the gas flow,

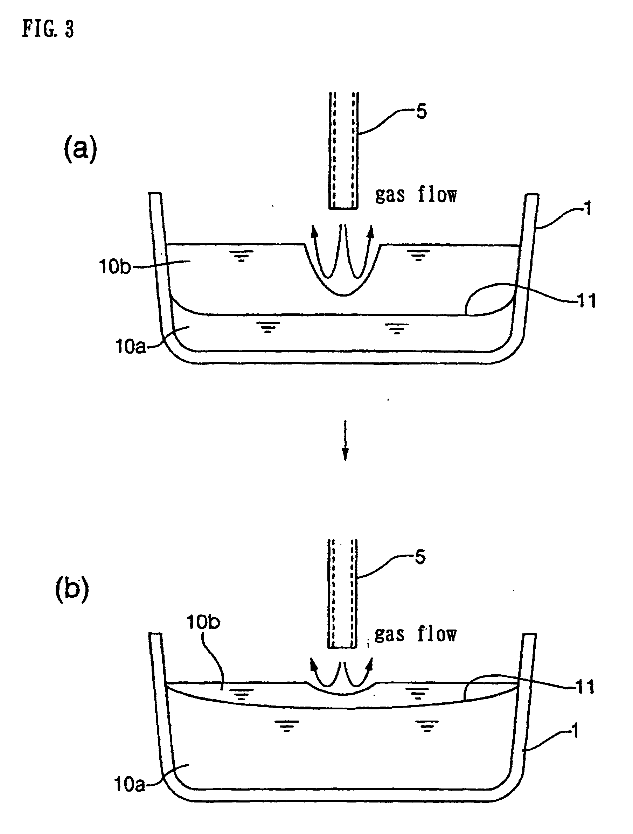

- Fig. 3: is a view showing a positional relation between the gas flow rate and the solid-liquid phase boundary, and
- Fig. 4(a): is a schematic sectional view of the front of another example of a susceptor which is provided to an equipment for producing crystalline silicone used in the embodiment of the method for producing a crystalline silicon according to the present invention, and
- Fig. 4(b): is a plan of Fig. 4(a) for illustrating a gas flow.

In the drawings, a mold 1 is set up in a chamber which is not shown in the drawings. Above the mold 1, an upper heater 2a is arranged, and a lower heater 2b under a chill plate 3 which is arranged beneath the mold. A thermal insulator 4 surrounds the mold 1,the upper heater 2a, the lower heater 2b and the chill plate 3. A gas-supplying lance 5 is arranged in the upper part of the mold 1,
which is inserted from the outside of the thermal insulator 4. A susceptor 6 which fits the gas-supplying lance 5 in the center thereof is arranged near an opened part 1a of the mold 1 such that the opened part 1a of the mold 1 is almost shut up.

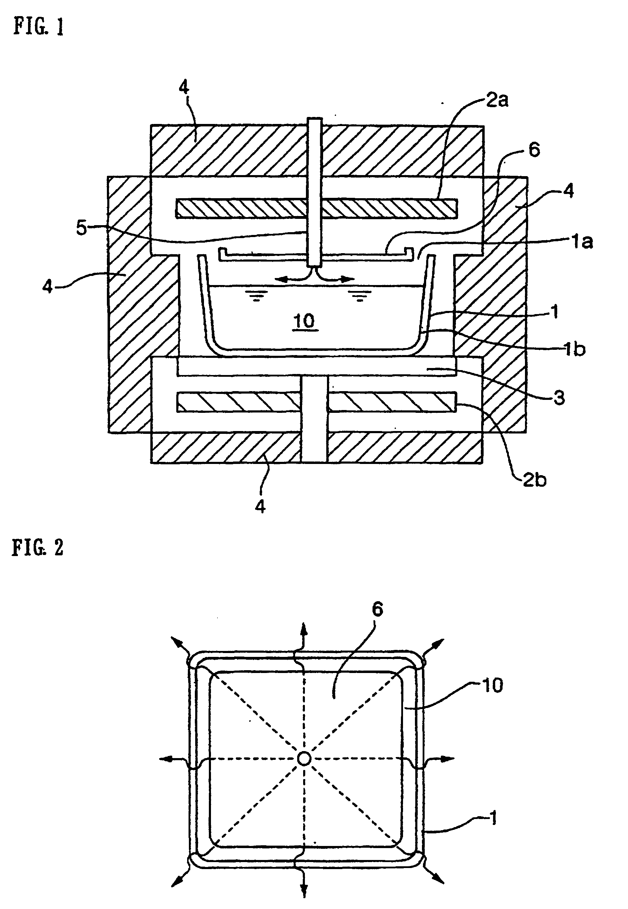

First, solid silicon as raw material is charged in the mold 1 when a crystalline silicone is produced using the above-mentioned equipment. Then, an inert gas as an atmosphere gas is introduced into the chamber from the upper part of the chamber which is not shown in the drawings and then the solid silicon in the mold is heated and melted by the upper heater 2a and lower heater 2b to make the solid silicon be molten silicon 10. Next, an inert gas, for example, Ar gas, is supplied from the gas-supplying lance 5, to cover the surface of the molten silicon, to make such a gas flow as shown by arrow symbols in Fig.2 and to blow the gas, thereby to vibrate the surface of the molten silicon by the blown gas such that cavities are formed in the surface thereof. After that, heating by the lower heater 2b is stopped and cooling the molten silicon in the mold by the chill plate 3 is started . In this step, the molten silicon is cooled by the chill plate starting from the bottom part 1b of the mold. The molten silicon is unidirectionally crystallized along a positive temperature gradient formed from the bottom part 1b upward.

As mentioned above, as the Ar gas is blown to the surface of the molten silicon from the upper position by the gas-supplying lance, vibration occurs in the surface and fresh faces are always formed in the surface of the molten surface. Therefore, the exhaustion of a SiO gas to the surrounding atmosphere is promoted which generates in the interior of the molten silicon with the result that O can be effectively removed which is an impurity in the molten silicon. In addition, the contamination with a CO gas from the surrounding atmosphere is prevented by this gas flow. As the solidification is continued in the above-mentioned state, the ingot of a crystalline silicon having a low content of impurities such as C and O is obtained after the solidification has finished. Further, a high quality of crystalline silicone having an excellent crystallinity is obtained because of having a low content of impurities according to the above-mentioned method.

Furthermore, as the opened part 1a of the mold is almost shut up by the susceptor 6 and the inert gas supplied from the gas-supplying lance covers the surface of the molten silicon, the CO gas, SiO gas and the like are prevented from entering into the molten silicon from the surface thereof.

Still furthermore, the crystalline silicon is obtained at a low cost, as it is enough if only the lance is arranged in the upper position of the mold so as to blow the inert gas to the surface of the molten silicon.

For the sake of deoxidization, it is necessary to provide a gas flow such as shown in Fig. 2 without completely closing the opened part 1a of the mold.

### EXAMPLES

Ingots of crystalline silicon were produced using the above-mentioned equipment for producing a crystalline silicon according to the present invention. A mold was used which was made of quartz and had a dimension of about 17 × 17 × 11 [cm] . A 3 kg of end material which was made of a single crystal silicon for semiconductor was used as a raw material of solid silicon. Heating was carried out up to 1500°C in one hour by heaters and the melting of the raw material was finished in 1.5 hours after the heating up. The prescribed gas flow rate was set up after the melting had finished. A Ar gas was used for an atmosphere gas in the chamber

The gas-supplying lance was arranged at a location of H = 1.0, 5.0, 12.0 and 20 [cm] which showed a height of head of the lance measured upward from the surface of the molten metal. The Ar gas was blown to the surface of the molten silicon at a flow rate of 2, 10, 40 and 60 [l/min] . The gas-supplying lances were used which had the following inside radius (r): r = 0.25, 0.5 [cm] .

With regard to a gas flow rate, the rate was successively decreased according to the upward movement of the solid-liquid phase boundary. Thereby, the solid-liquid phase boundary was prevented from being disturbed with the result that a crystalline silicon having an excellent crystallinity can be produced.

As a comparative example, the following case was carried out.

| | |
|---|---|
| Inside radius of gas-supplying lance | r = 0.25 [cm] |
| Position of lance | at 300mm obliquely upward from the surface of molten silicon |
| Gas flow rate | 10 [l/min] |

The results of the impurities of thus-obtained ingots are shown in Table 1.

The height of the obtained ingots were about 5cm. With regard to both the examples of the present invention and the comparative example, C and O contents were measured in the center of the face of a wafer obtained at a height of 2.0 [cm] from the bottom of each ingot.

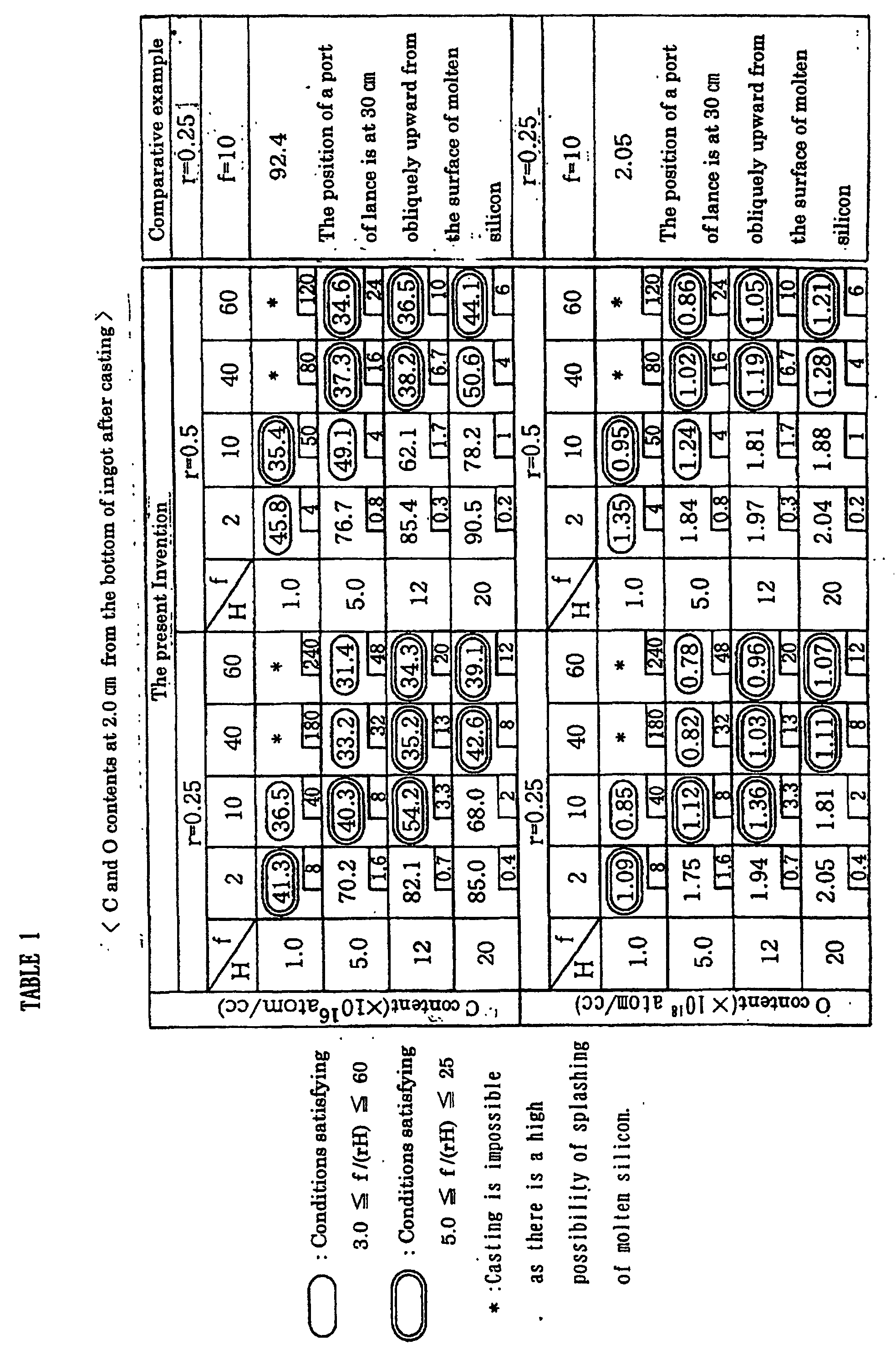

In the Table 1, ⓞ are conditions satisfying 5.0 ≦ f/(rH) ≦ 25 and ○ are conditions satisfying 3.0 ≦ f/(rH) ≦ 60. Symbols * are conditions wherein a molten silicon splashed and sputtered to the upper heater. The upper half of the Table shows C contents and the lower half shows O contents. The numeral which is shown in the right-under of each content shows a value of f /(rH).

In cases of satisfying the conditions of 3 >f/(rH) , both the C and O contens are high. In contrast, in cases of satisfying the conditions of 3 ≦ f/(rH) < 5, the C and O contents relatively decrease. In cases of satisfying the conditions of 5.0 ≦ f/(rH) ≦ 25, the C and O contents decrease approximately to a half as compared with the cases of 3 >f/(rH) . In cases of satisfying the conditions of f/(rH)> 25 , though the C and O contents further decrease, the crystallinity in the cell was disturbed and the cell properties lowered as it was difficult to control in such a manner that the solid-liquid phase boundary was not disturbed.

From the examples of the present invention, it is found that the C and O contents of the crystalline silicon are lower than those of the conventional example if the condition of 3.0 ≦ f/(rH) ≦ 60 is satisfied. Especially, in case of 5.0 ≦ f/(rH) ≦ 25 being satisfied, the C and O contents are greatly decreased.

In cases having a larger r, the impurity contents increase and in cases having r larger than 3 [cm] , any effect is not found in decreasing the impurity contents as compared with the conventional example.

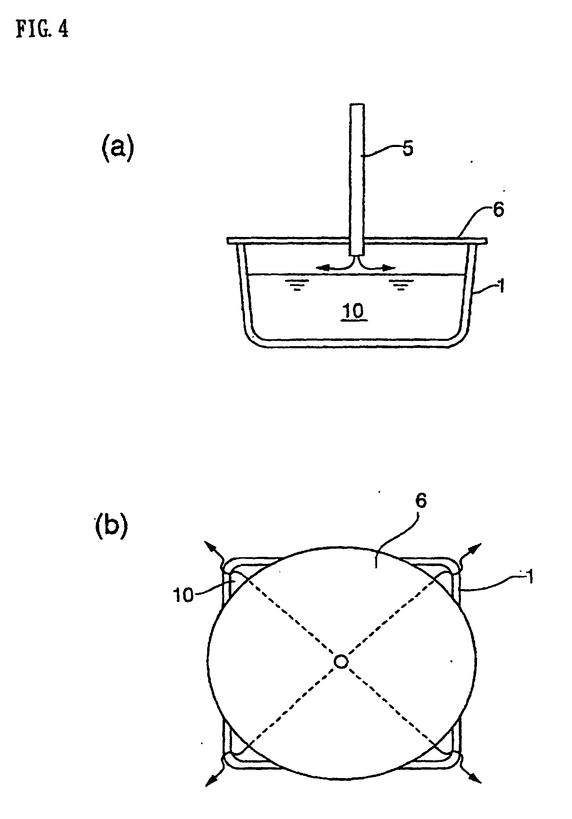

With regard to the susceptor, as shown in Fig.4, a susceptor can be used which has a larger size in a part of the diameter than the opened part of the mold and can be loaded on the opened part of the mold.

With regard to the gas-supplying lance, a plurality of lances can be used in case of a molten silicon having a large surface area.

As mentioned above in detail, the following effects are obtained according to the method for producing a crystalline silicon of the preset invention:
(1) According to the first aspect of the present invention relating to a process for producing a crystalline silicon, a crystalline silicon can be produced which has a low impurity content and an excellent crystallinity since the solidification and crystallization are carried out while removing effectively O which is an impurity of the molten silicon by promoting to discharge a SiO gas generating in the interior of the molten silicon to the surrounding atmosphere during the crystallization.
(2) According to the second aspect of the present invention relating to a process for producing a crystalline silicon, impurity gases such as CO gas and SiO gas in the surrounding atmosphere are prevented from entering into the molten silicon.
(3) According to the third aspect of the present invention relating to a process for producing a crystalline silicon, a CO gas and SiO gas in the surrounding atmosphere is effectively prevented from entering into the molten silicon by a small flow rate of an inert gas.
(4) According to the fourth aspect of the present invention relating to a process for producing a crystalline silicon, a solid-liquid phase boundary is restrained from being disturbed by a blown inert gas with the result that a crystalline silicon having an excellent crystallinty is obtained.
(5) According to the fifth aspect of the present invention relating to a process for producing a crystalline silicon, a crystalline silicon having a greatly decreased O content can be produced since the surface of the molten silicon is effectively and properly vibrated by selecting a flow rate of the blown inert gas, an inside radius of the gas-supplying lance and a distance from a port of the lance to the surface of the molten silicon so as to promote to discharge to the surrounding atmosphere a SiO gas which generates in the interior of the molten silicon, thereby to remove O which is an impurity in the molten metal.
(6) According to the sixth aspect of the present invention relating to a process for producing a crystalline silicon, O can be decreased which is an impurity in the molten silicon since the surface of the molten silicon is vibrated by selected number of lance(s) according to the surface area of the molten silicon so as to be effective and proper for promoting to discharge to the surrounding atmosphere a SiO gas which generates in the interior of the molten silicon.

## Claims

1. Method for producing crystalline silicon, said method comprising:
crystallizing molten silicon (10) from the inner bottom of a mold (1) upward while providing to the molten silicone (10) in the mold (1) a temperature having a positive gradient from the inner bottom of the mold upward,
blowing during crystallizing an inert gas to the surface of the silicon to vibrate the surface of the molten silicon in such a manner that cavities are formed in the surface thereof, whereby the blowing of the inert gas onto the surface continues during solidification,
a susceptor (6) being disposed above the surface of the molten silicon (10) and the inert gas being introduced into the space between the susceptor (6) and the surface of the molten silicon (10) through a part of the susceptor (6).

2. Method as claimed in claim 1, wherein the surface of the molten silicon (10) is covered with the inert gas.

3. Method as claimed in claim 1 or 2, wherein the flow rate of the blown inert gas is decreased according to moving of the solid-liquid phase boundary of the molten silicon (10) in the mold upward.

4. Method as claimed in one of claims 1 to 3, wherein the flow rate of the blown inert gas, the inside radius of a gas-supplying lance (5) which introduces the inert gas into the surface of the molten silicon (10) and the distance from the port of the lance to the surface of the molten silicon satisfy the following formula:$\text{3 ≤ f/(rH) ≥ 60}$ wherein
f [ l/min ] is the flow rate of blown inert gas;
r [ cm ] is the inside radius of the lance; and
H[ cm ] is the distance from the port of the lance to the surface of molten silicon.

5. Method as claimed in one of claims 1 to 4, wherein the inert gas is blown through on or more lances (5) into the surface of the molten silicon (10) according to the surface area of the molten silicon.

## Patentansprüche

1. Verfahren für die Herstellung eines kristallinem Siliziums, das folgende Schritte umfasst:
Kristallisierung von geschmolzenem Silizium (10) von der Innenseite einer Gussform (1) in der oberen Richtung, während das geschmolzene Silizium (10) in der Gussform (1) auf eine Temperatur gebracht wird, die einen positiven Gradienten zwischen dem inneren Boden der Gussform und der oberen Richtung der Gussform aufweist,
Einblasen eines inerten Gases während der Kristallisierung auf die Oberfläche des Siliziums, um dadurch die Oberfläche des geschmolzenen Siliziums so zu vibrieren, dass in dessen Oberfläche Kavitäten erzeugt werden, so dass das Einblasen des inerten Gases auf die Oberfläche während der Verfestigung fortgeführt werden kann,
Anordnung eines Phasenkompensators (6) über der Oberfläche des geschmolzenen Siliziums (10) und Einleitung des inerten Gases in den Zwischenraum zwischen dem Phasenkompensator (6) und der Oberfläche des geschmolzenen Siliziums (10) über einen Teil des Phasenkompensators.

2. Verfahren nach Anspruch 1,
**dadurch gekennzeichnet, dass**
die Oberfläche des geschmolzenen Siliziums (10) von dem inerten Gas überdeckt wird.

3. Verfahren nach einem der Ansprüche 1 oder 2,
**dadurch gekennzeichnet, dass**
die Strömungsrate des eingeblasenen inerten Gases entsprechend der Verschiebung der Grenze der festen/flüssigen Phase des geschmolzenen Siliziums (10) in der oberen Richtung in der Gussform (10) verringert wird.

4. Verfahren nach einem der Ansprüche 1 oder 3,
**dadurch gekennzeichnet, dass**
die Strömungsrate des eingeblasenen inerten Gases, der innere Radius der Gaslanze (5), mit deren Hilfe das inerte Gas in die Oberfläche des geschmolzenen Siliziums (10) eingeleitet wird, und der Abstand zwischen dem Einlass der Gaslanze und der Oberfläche des geschmolzenen Siliziums der folgenden Gleichung entsprechen:$\text{3 ≥ f/(rH) ≤ 60}$ darin ist
f[l/min] die Fließrate des eingeblasenen inerten Gases;
r[cm] der innere Radius der Gaslanze; und
H[cm] der Abstand zwischen dem Einlass der Gaslanze und der Oberfläche des geschmolzenen Siliziums

5. Verfahren nach einem der Ansprüche 1 bis 4,
**dadurch gekennzeichnet, dass**
das inerte Gas mit Hilfe von einer oder mehreren Gaslanzen (5) auf die Oberfläche des geschmolzenen Siliziums (10) entsprechend dem Oberflächenbereich des geschmolzenen Siliziums geblasen wird.

## Revendications

1. Procédé pour la production de silicium cristallin comprenant les étapes suivantes:
cristallisation d'un silicium (10) fondu à partir du fond d'un moule (1) dans la direction supérieure du moule pendant que le silicium (10) fondu contenu dans le moule (1) est maintenu à une température présentant un gradient positif entre le fond intérieur du moule vers le haut du moule,
soufflage pendant la cristallisation d'un gaz inerte sur la surface du silicium afin de vibrer ainsi la surface du silicium fondu de telle sorte que des cavités sont formées dans cette surface pour continuer ainsi le soufflage du gaz inerte sur la surface pendant la solidification,
disposition d'un déphaseur (6) au-dessus de la surface du silicium (10) fondu et introduction du gaz inerte dans l'espace situé entre le déphaseur (6) et la surface du silicium (10) à travers d'une partie du déphaseur (6).

2. Procédé suivant la revendication 1,
**caractérisé en ce que**
la surface du silicium (10) fondu est couvert par le gaz inerte.

3. Procédé suivant l'une des revendications 1 ou 2,
**caractérisé en ce que**
le taux d'écoulement du gaz insufflé est réduit conformément au mouvement de la limite de la phase solide/liquide du silicium (10) fondu dans le moule dans la direction supérieure de ce moule.

4. Procédé suivant l'une des revendications 1 à 3,
**caractérisé en ce que**
le taux d'écoulement du gaz inerte insufflé, le rayon intérieur d'une lance de gaz (5) délivrant le gaz inerte sur la surface du silicium (10) fondu, et la distance entre l'entrée de la lance et la surface du silicium fondu correspondent à l'équation suivante:$\text{3≥f/(rH)≤60}$ dans lequel est
f[l/min] représente le taux d'écoulement du gaz insufflé;
r[cm] représente le rayon intérieur de la lance de gaz; et
H[cm] représente la distance entre l'entrée de la lance de gaz et la surface du silicium fondu

5. Procédé suivant l'une des revendications 1 à 4,
**caractérisé en ce que**
le gaz inerte est soufflé par l'intermédiaire d'une ou plusieures lances de gaz (5) sur la surface du silicium (10) conformément à la dimension de la surface du silicium fondu.
